# EUROPÄISCHE PATENTANMELDUNG

(11) **EP 3 640 660 A1**
(43) Veröffentlichungstag der Anmeldung: **22.04.2020**
(21) Anmeldenummer: 18200728.6
(22) Anmeldetag: 16.10.2018
(51) Int. Cl.: G01R 33/54, G01R 33/385

(54) **VERFAHREN ZUM BETRIEB EINER MAGNETRESONANZEINRICHTUNG**

(71) Anmelder: Siemens Healthcare GmbH, 91052 Erlangen (DE)
(72) Erfinder: Biber, Stephan, 91056 Erlangen (DE); Grodzki, David, 91058 Erlangen (DE)

(57) **Zusammenfassung**

Verfahren zum Betrieb einer Magnetresonanzeinrichtung (1) sowie zugehörige Magnetresonanzeinrichtung, Computerprogrammprodukt und elektronisch lesbarer Datenträger, umfassend die Schritte:
- Vorgeben einer geplanten Messsequenz (35),
- Erfassen einer aktuellen Temperatur (30) wenigstens einer Komponente (2 - 5, 7, 10) der Magnetresonanzeinrichtung (1) durch einen jeweiligen Temperatursensor (13) der Magnetresonanzeinrichtung (1), und
- Ermitteln einer jeweiligen Prognosetemperatur (33) für die Komponente (2 - 5, 7, 10) oder wenigstens eine der Komponenten (2 - 5, 7, 10) für wenigstens einen Zeitpunkt während der Ausführung und/oder nach Abschluss der geplanten Messsequenz (35) in Abhängigkeit der aktuellen Temperatur (30) und der geplanten Messsequenz (35).

## Beschreibung

Die Erfindung betrifft ein Verfahren zum Betrieb einer Magnetresonanzeinrichtung. Daneben betrifft die Erfindung eine Magnetresonanzeinrichtung, ein Computerprogramm sowie einen elektronisch lesbaren Datenträger.

Magnetresonanzeinrichtungen, insbesondere Magnetresonanzeinrichtungen zur medizinischen Bildgebung, weisen zahlreiche Komponenten auf, die, typischerweise aktiv, gekühlt werden. Haupterzeuger von Abwärme sind hierbei die Gradientenspulen, Gradientenverstärker, die zum Bestromen der Gradientenspulen genutzt werden, der Kompressor zum Betrieb eines Kaltkopfes zum Kühlen des Magneten sowie die Hochfrequenzleistungsverstärker. Auch für Komponenten mit geringerem Energiebedarf, beispielsweise Bild- und Steuerrechner und Transformatoren der Netzteile, ist typischerweise eine Kühlung erforderlich.

Heutige Kühlsysteme werden typischerweise mit mehreren Sensoren zur Überwachung des Durchflusses und der Temperatur bestückt. Die Sensoren werden von einer Elektronik des Kühlsystems ausgelesen und die Informationen auf einem standardisierten Bus-System, beispielsweise einem CAN-, SPI- oder I2C-Bus, an die Steuereinrichtung des Systems übergeben.

Aus der Druckschrift DE 20 2017 001 501 U1 ist es bekannt, zur Reduzierung des erforderlichen Überwachungsaufwands nur an Teilen der Komponenten Sensoren anzuordnen und in Abhängigkeit der Messwerte für diese Komponenten Temperaturen für weitere Komponenten zu berechnen. Die Überwachung von Komponententemperaturen kann hierbei insbesondere dazu dienen, einen kurzfristigen Betrieb von Komponenten mit einer Leistung, die höher liegt als ihre Dauerleistung, zu überwachen.

Während eine derartige Überwachung von Komponententemperaturen gut geeignet ist, um Beschädigungen aufgrund von Komponenten zu vermeiden, können insbesondere bei Messsequenzen, die einzelne Komponenten über ihre Dauerleistungsfähigkeit hinaus beanspruchen, unerwartete Sequenzabbrüche auftreten, wenn im Rahmen der Sequenz hohe Komponententemperaturen ermittelt werden. Derartige unerwartete Sequenzabbrüche können dazu führen, dass eine Messsequenz vollständig wiederholt werden muss, wobei typischerweise zuvor eine Wartezeit zum Abkühlen der Komponenten der Magnetresonanzeinrichtung abgewartet werden muss. Sequenzabbrüche können somit zu einer erheblichen Verzögerung der Messung führen, was einerseits den Patientenkomfort senken kann und andererseits den Durchsatz der Magnetresonanzeinrichtung senken kann.

Der Erfindung liegt somit die Aufgabe zugrunde, Sequenzabbrüche und die hieraus resultierende Verzögerung des Messbetriebs möglichst weitgehend zu vermeiden.

Die Aufgabe wird erfindungsgemäß durch ein Verfahren zum Betrieb einer Magnetresonanzeinrichtung gelöst, das die folgenden Schritte umfasst:
- Vorgeben einer geplanten Messsequenz,
- Erfassen einer aktuellen Temperatur wenigstens einer Komponente der Magnetresonanzeinrichtung durch einen jeweiligen Temperatursensor der Magnetresonanzeinrichtung, und
- Ermitteln einer jeweiligen Prognosetemperatur für die Komponente oder wenigstens eine der Komponenten für wenigstens einen Zeitpunkt während der Ausführung und/oder nach Abschluss der geplanten Messsequenz in Abhängigkeit der aktuellen Temperatur und der geplanten Messsequenz.

Es wird somit vorgeschlagen, nicht nur eine aktuelle Komponententemperatur zu berücksichtigen, sondern stattdessen in Abhängigkeit einer geplanten Messsequenz zu prognostizieren, welche Temperaturen voraussichtlich zukünftig vorliegen werden. Somit wird einerseits durch die Berücksichtigung der aktuellen Temperaturen ein aktueller Zustand der Magnetresonanzeinrichtung und somit effektiv auch die Auswirkung des bisherigen Betriebs der Magnetresonanzeinrichtung berücksichtigt. Andererseits wird durch Berücksichtigung der geplanten Messsequenz ermöglicht, zumindest näherungsweise vorauszusagen, wie sich die aktuellen Temperaturen zukünftig entwickeln werden. Dies ermöglicht es, bereits vor dem Beginn der Durchführung der geplanten Messsequenz zu erkennen, ob voraussichtlich Temperaturen an einzelnen Komponenten auftreten werden, die einen Abbruch der Sequenz erfordern würden. Wie später noch genauer erläutert werden wird, kann ein Benutzer beispielsweise in diesem Fall informiert werden, dass bei einer tatsächlichen Durchführung der geplanten Messsequenz ein Sequenzabbruch droht, die geplante Messsequenz kann automatisch modifiziert und/oder verzögert werden oder einem Benutzer kann eine entsprechende Modifikation oder Verzögerung vorgeschlagen werden. Durch das erfindungsgemäße Vorgehen kann zumindest ein Großteil von Sequenzabbrüchen aufgrund überhöhter Komponententemperaturen vermieden werden. Hierdurch wird insgesamt ein höherer Durchsatz für die Magnetresonanzeinrichtung erreicht und der Patientenkomfort erhöht.

Komponenten, deren aktuelle Temperaturen erfasst werden bzw. für die Prognosetemperaturen ermittelt werden, können beispielsweise Gradienten- und/oder Hochfrequenzspulen, Komponenten zur Ansteuerung dieser Spulen, beispielsweise Verstärker oder Filter, oder eine Kühleinheit sein.

Die Prognosetemperatur für eine Komponente hängt insbesondere von der aktuellen Temperatur der gleichen Komponente und/oder von der aktuellen Temperatur wenigstens einer weiteren Komponente ab. Die Prognosetemperatur kann für fest vorgegebene Zeitpunkte ermittelt werden. Es ist jedoch beispielsweise auch möglich, dass als Prognosetemperatur die maximale Temperatur ermittelt wird, die im Rahmen der Messsequenz auftreten wird. Die Prognose der Prognosetemperatur kann mit relativ einfachen Modellen erfolgen. Beispielsweise ist es ausreichend, wenn ein Auftreten von Temperaturen, die zu einem Sequenzabbruch führen würden, für 95 % jener Fälle prognostiziert wird, bei denen entsprechende Temperaturen tatsächlich auftreten würden. Bereits hierdurch kann eine Reduzierung der Sequenzabbrüche um den Faktor 20 erreicht werden und somit eine erhebliche Verbesserung des Durchsatzes und des Patientenkomforts. Die Nutzung eines relativ einfachen Modells, durch das beispielsweise nur einige wenige Kerngrößen einer Messsequenz berücksichtigt werden, ermöglicht eine sehr schnelle Ermittlung der Prognosetemperatur beziehungsweise Prognosetemperaturen, womit das erfindungsgemäße Verfahren Prognosetemperaturen ohne eine merkliche Verzögerung, also für einen Benutzer gefühlt in Echtzeit, ermitteln kann.

Das erfindungsgemäße Verfahren kann beispielsweise dazu genutzt werden, einen Benutzer, also beispielsweise einen Arzt oder medizinisches oder technisches Bedienpersonal, über die Prognosetemperatur zu informieren und/oder darauf hinzuweisen, dass der Abbruch der geplanten Messsequenz droht. Besonders bevorzugt greift das erfindungsgemäße Verfahren jedoch aktiv in den Messbetrieb ein.

Insbesondere kann die Ausführung der geplanten Messsequenz von der Erfüllung einer von der Prognosetemperatur abhängigen Ausführbedingung abhängen. Beispielsweise kann die geplante Messsequenz nur dann ausgeführt werden, wenn die Ausführbedingung erfüllt ist. Die Ausführbedingung kann beispielsweise auch eine Nichterfüllung einer Sperrbedingung sein, die von der Prognosetemperatur abhängt. Die Ausführbedingung beziehungsweise Sperrbedingung kann die Prognosetemperatur beziehungsweise jede der Prognosetemperaturen mit einem jeweiligen Grenzwert vergleichen und beispielsweise nur dann erfüllt sein, wenn keiner der Grenzwerte überschritten wird.

Bei Nichterfüllung der Ausführbedingungen kann wenigstens ein Sequenzparameter der geplanten Messsequenz modifiziert werden und statt der geplanten Messsequenz die derart modifizierte Messsequenz ausgeführt werden. Beispielsweise können maximal genutzte Gradientenfelder beziehungsweise eine maximale Änderungsgeschwindigkeit für die Gradientenfelder begrenzt werden, modifizierte Pulssequenzen genutzt werden, Zeitabstände zwischen der Erfassung einzelner Schichten angepasst werden oder Ähnliches. Hierbei ist es möglich, dass eine entsprechende Modifikation vollautomatisch erfolgt. Besonders bevorzugt erfolgt vorangehend jedoch eine Rückfrage beim Benutzer, ob eine entsprechende Modifikation gewünscht ist oder ob beispielsweise stattdessen eine Verzögerung der Messung erfolgen soll. Beispielsweise kann in einigen Fällen die Messsequenz derart modifiziert werden, dass die Qualität der Messdaten kaum merklich leidet, wobei rechtzeitig längere Verzögerungszeiten vermieden werden können.

Bei Nichterfüllung der Ausführbedingung kann die geplante Messsequenz nicht ausgeführt werden. Alternativ kann die geplante oder die modifizierte Messsequenz erst bei Erfüllung einer Auslösebedingung ausgeführt werden.

Die Erfüllung der Auslösebedingung kann von einem seit der Prüfung der Erfüllung der Ausführbedingung verstrichenen Zeitintervall oder von dem Erfassen einer Bestätigungseingabe eines Benutzers abhängen oder nach Nichterfüllung der Ausführbedingung kann zu wenigstens einem Prüfzeitpunkt für wenigstens eine Komponente eine weitere Temperatur erfasst werden, wobei die Erfüllung der Auslösebedingung von der weiteren Temperatur oder einer in Abhängigkeit der weiteren Temperatur prognostizierten weiteren Prognosetemperatur abhängt.

Ein Warten für ein gewisses Zeitintervall kann beispielsweise zweckmäßig sein, wenn eine oder mehrere der Komponenten der Magnetresonanzeinrichtung aufgrund einer vorangehend durchgeführten Sequenz oder mehrerer vorangehend durchgeführter Sequenzen eine relativ hohe aktuelle Temperatur aufweist oder aufweisen, die bei Durchführung der geplanten Messsequenz oder auch einer modifizierten Messsequenz zu einem Sequenzabbruch führen könnte. Durch ein Abwarten eines gewissen Zeitintervalls kann diese Temperatur wieder absinken, wodurch die geplante beziehungsweise modifizierte Messsequenz voraussichtlich ohne Sequenzabbruch durchgeführt werden kann. Dies führt zwar zu einer Verzögerung des Messbetriebs, diese ist jedoch erheblich geringer als eine Verzögerung, die resultieren würde, wenn zunächst versucht würde, die geplante beziehungsweise modifizierte Messsequenz sofort durchzuführen und dies zu einem Sequenzabbruch führen würde. Das Erfassen einer Bestätigungseingabe eines Benutzers kann insbesondere dann vorteilhaft sein, wenn dem Benutzer vorangehend an einer Ausgabeeinrichtung bezüglich der Durchführung der geplanten beziehungsweise modifizierten Messsequenz relevante Informationen ausgegeben werden. Beispielsweise kann der Benutzer wählen, ob eine modifizierte Messsequenz genutzt werden soll oder ob stattdessen eine längere Verzögerung in Kauf genommen werden soll und die geplante Messsequenz durchgeführt werden soll. Andererseits kann es auch vorteilhaft sein, den Benutzer zu informieren, wie hoch das tatsächliche Abbruchrisiko für die aktuelle geplante beziehungsweise modifizierte Messsequenz tatsächlich ist, so dass der Benutzer selbst entscheiden kann, ob er einen Sequenzabbruch riskieren möchte.

Statt der vorangehend erläuterten Verzögerung der Messsequenz um ein festes Zeitintervall kann es vorteilhaft sein, stattdessen zu warten, bis die Temperatur einer Komponente beziehungsweise eine hieraus prognostizierte weitere Prognosetemperatur ausreichend weit abgefallen ist, um voraussichtlich ein Ausspielen der Messsequenz ohne Sequenzabbruch zu ermöglichen. Ein derartiges Vorgehen kann besonders vorteilhaft sein, wenn Komponententemperaturen ohnehin regelmäßig erfasst werden und insbesondere ein relativ wenig rechenaufwendiges Modell zur Prognose der Prognosetemperatur genutzt wird. In diesem Fall kann mit minimalem Zusatzaufwand durch Berücksichtigung der weiteren Temperatur beziehungsweise der weiteren Prognosetemperatur ein optimaler Zeitpunkt zum Ausspielen der Messsequenz ermittelt werden.

Die geplante Messsequenz kann wenigstens einen Sequenzparameter aufweisen, der die Ansteuerung wenigstens einer Komponente der Magnetresonanzeinrichtung im Rahmen der Messsequenz betrifft, wobei die Prognosetemperatur in Abhängigkeit des Sequenzparameters ermittelt wird. Die Komponente, deren Ansteuerung der Sequenzparameter betrifft, kann eine Komponente sein, deren aktuelle Temperatur erfasst wird und/oder wenigstens eine weitere Komponente. Bei dem im Rahmen der Ermittlung der Prognosetemperatur berücksichtigten Sequenzparameter kann es sich um die gleichen Sequenzparameter handeln, die modifiziert werden können, um die modifizierte Messsequenz zu bestimmen, um aus diesen bestimmte Parameter oder um vollständig andere Parameter.

Es kann ein mathematisches Modell der Magnetresonanzeinrichtung genutzt werden, um in Abhängigkeit des wenigstens einen Sequenzparameters und in Abhängigkeit der wenigstens einen aktuellen Temperatur die wenigstens eine Prognosetemperatur zu ermitteln. Das Modell kann insbesondere derart implementiert sein, dass die Prognosetemperatur als Funktion des Sequenzparameter und der aktuellen Temperatur ermittelt wird. Hierbei kann eine jeweilige Prognosetemperatur auch von mehreren aktuellen Temperaturen abhängen. Das Modell kann beispielsweise durch statistische Auswertung von vorangehend durchgeführten Sequenzen mit dabei auftretenden Temperaturen, ein Verfahren des Maschinenlernens oder Ähnliches ermittelt werden. Hierbei kann ein Modell für eine bestimmte Magnetresonanzeinrichtung beziehungsweise einen bestimmten Typ von Magnetresonanzeinrichtung ermittelt werden. Besonders bevorzugt wird jedoch ein allgemeines Modell ermittelt, indem auf verschiedenen Magnetresonanzeinrichtungen durchgeführte Sequenzen und die dabei aufgetretenen Temperaturen berücksichtigt werden. Dies ermöglicht es, das Modell einfacher durch Vorgabe entsprechender Parameter an verschiedene Magnetresonanzeinrichtungen beziehungsweise verschiedene Typen von Magnetresonanzeinrichtungen anzupassen.

Als Sequenzparameter können ein Sequenztyp und/oder eine Laufzeit und/oder ein voraussichtlicher Leistungseintrag und/oder Energieeintrag in Komponenten zur Erzeugung von Gradientenfeldern und/oder von Hochfrequenzpulsen und/oder ein Frequenzgehalt und/oder maximale und/oder mittlere Feldstärken des geplanten zeitlichen Verlaufs der Gradientenfelder und/oder der Hochfrequenzpulse bei der Ermittlung der Prognosetemperatur berücksichtigt werden.

Insbesondere kann die Prognosetemperatur beziehungsweise können die Prognosetemperaturen eine Funktion von zumindest Teilen der genannten Sequenzparameter sein. Beispielsweise kann die Prognosetemperatur für eine Komponente von einem Energieeintrag in ein entsprechendes Subsystem der Magnetresonanzeinrichtung, also beispielsweise die Komponenten zur Gradientenerzeugung in eine Richtung, abhängen. Dieser Energieeintrag kann, unter Umständen nach einer Skalierung, um das Zeitintegral der verfügbaren Kühlleistung über die Sequenzlaufzeit verringert werden, um einen Temperaturunterschied zwischen der aktuellen Temperatur und der Prognosetemperatur zu ermitteln.

Ein Energieeintrag in ein Gradientensystem und somit auch eine Prognosetemperatur kann jedoch auch ermittelt werden, indem für die einzelnen Gradientenrichtungen ein zeitlicher Verlauf des jeweiligen Gradientenfeldes vorgegeben wird. Durch Berechnung eines Integrals über das Quadrat der Gradientenfeldstärke und anschließendes Wurzelziehen kann, wenn ein entsprechender Skalierungsfaktor, der eine Eigenschaft der Magnetresonanzeinrichtung ist, bekannt ist, ein Energieeintrag zur Erzeugung des jeweiligen Gradientenfeldes berechnet werden. Durch Summation der Energieeinträge für alle drei Gradientenrichtungen und ein Addieren eines Grundenergieeintrags, der stets beim Betrieb des Gradientensystems eingebracht wird, kann beispielsweise der Gesamtenergieeintrag für das Gradientensystem berechnet werden.

Es kann häufig auch ausreichend sein, mittlere Energieeinträge beziehungsweise Feldstärken als Sequenzparameter zu berücksichtigen. Ist die Laufzeit der Sequenz bekannt, ist es häufig ausreichend, das Produkt aus Laufzeit und voraussichtlichem mittleren Leistungseintrag zu bilden, um eine Temperaturänderung der aktuellen Temperatur prognostizieren zu können.

Es kann hochrelevant sein, den Sequenztyp der Messsequenz zu berücksichtigen. Beispielsweise werden bei einer Diffusionsbildgebung, beispielsweise bei einem "Diffusion Weighted Imaging" oder einem "Diffusion Tensor Imaging", Leistungseinträge erreicht, die zwei bis vier Mal größer sein können als sie bei anderen Sequenztypen, beispielsweise einem Gradientenecho oder einem Turbo-Spin-Echo, sind.

Die Prognosetemperatur kann anhand eines Modells der Magnetresonanzeinrichtung ermittelt werden, das in Abhängigkeit wenigstens eines eine Eigenschaft der Magnetresonanzeinrichtung beschreibenden Einrichtungsparameters parametrisiert ist oder wird. Das Modell der Magnetresonanzeinrichtung kann insbesondere Gleichungen für die Prognosetemperaturen der einzelnen Komponenten angeben, die von den aktuellen Temperaturen der jeweiligen oder auch anderen Komponenten abhängen und durch die Einrichtungsparameter parametrisiert sind. Das Modell der Magnetresonanzeinrichtung kann auf theoretischen Vorüberlegungen basieren, beispielsweise indem verschiedene Wärmetransportpfade erkannt und anhand von bekannten Parametern zu einem Modell zusammengefügt werden. Es ist jedoch auch möglich, ein entsprechendes Modell dadurch zu ermitteln, dass für eine Vielzahl von durchgeführten Messsequenzen und aktuellen Temperaturen der Komponenten vor Beginn der Messsequenz jeweils die im Rahmen der Messsequenz auftretenden Temperaturen erfasst werden und beispielsweise durch eine statistische Auswertung dieser Daten oder ein Verfahren des Maschinenlernens ein entsprechendes Modell parametrisiert wird.

Es kann ein Modell ermittelt werden, das spezifisch für eine bestimmte Magnetresonanzeinrichtung beziehungsweise einen bestimmten Typ von Magnetresonanzeinrichtung ist. Besonders bevorzugt hängt das Modell jedoch von einzelnen leicht zu ermittelnden Parametern der Magnetresonanzeinrichtung ab, so dass es leicht an verschiedenen Magnetresonanzeinrichtungen beziehungsweise Magnetresonanzeinrichtungstypen angepasst werden kann. Das Modell kann neben Parametern der Magnetresonanzeinrichtung selbst auch externe Parameter, beispielsweise eine Umgebungstemperatur oder eine Temperatur von extern zugeführtem Kühlfluid, berücksichtigen.

Als Einrichtungsparameter können ein Widerstand wenigstens einer Gradientenspule und/oder wenigstens einer Hochfrequenzspule, insbesondere ein temperaturabhängiger und/oder frequenzabhängiger Widerstand der Gradientenspule und/oder der Hochfrequenzspule, und/oder wenigstens eine die Speicherung und/oder den Transport von Wärmeenergie in der Magnetresonanzeinrichtung betreffende Einrichtungskonstante und/oder wenigstens ein Regelparameter, der ein Regelverhalten einer Kühleinheit und/oder einer Mischbatterie betrifft, verwendet werden.

Sollen frequenz- beziehungsweise temperaturabhängige Widerstände berücksichtigt werden, kann die Frequenz- beziehungsweise Temperaturabhängigkeit anhand von theoretischen Gleichungen ermittelt werden. Insbesondere bezüglich der Frequenzabhängigkeit wurde jedoch erkannt, dass die konkrete Frequenzabhängigkeit eines Widerstands der Gradienten- beziehungsweise Hochfrequenzspule von dem konkreten Aufbau der Wicklung abhängt, so dass je nach Wickeltechnik auch bei gleich aufgebauten Gradienten- beziehungsweise Hochfrequenzspulen Unterschiede im Frequenzverhalten des Widerstands auftreten können. Es kann daher vorteilhaft sein, den frequenzabhängigen Widerstand der Gradienten- beziehungsweise Hochfrequenzspulen an der konkret genutzten Spule zu ermitteln und beispielsweise in einer Look up-Tabelle abzulegen.

Die genannten Regelparameter können beispielsweise die Reaktion einer Kühleinheit, auch Chiller genannt, beziehungsweise von Mischbatterien auf Temperaturänderungen im System, insbesondere auf eine Änderung von Temperaturwerten an den Temperatursensoren, beschreiben. Beispielsweise kann von einem solchen Regelparameter abhängen, wie schnell sich ein Kühlfluidfluss ändert, wenn eine Temperaturerhöhung erkannt wird oder Ähnliches.

Die Einrichtungskonstante oder wenigstens eine der Einrichtungskonstanten kann eine Wärmekapazität und/oder eine Wärmeleitfähigkeit und/oder eine Temperaturleitfähigkeit der Gradientenspule und/oder der Hochfrequenzspule sein und/oder den Wärmetransport durch einen Kühlfluidfluss in der Magnetresonanzeinrichtung beschreiben. Die genannten Parameter wirken sich besonders stark auf die an den Komponenten auftretenden Temperaturen aus und können mit relativ geringem Aufwand für die einzelnen Komponenten ermittelt werden, so dass beispielsweise ein relativ allgemeines Modell für eine Vielzahl von Magnetresonanzeinrichtungen an die konkret genutzte Magnetresonanzeinrichtung beziehungsweise den konkret genutzten Typ von Magnetresonanzeinrichtung angepasst werden kann.

Während der Ausführung der geplanten oder der modifizierten Messsequenz kann wiederholt die momentane Temperatur der Komponente oder wenigstens einer der Komponenten erfasst werden, wonach bei Erfüllung einer Abbruchbedingung, deren Erfüllung von der momentanen Temperatur abhängt, die Messsequenz abgebrochen wird. Somit kann das vorangehend erläuterte Verfahren, bei dem ein Betrieb in Abhängigkeit von prognostizierten Temperaturen erfolgt, durch zusätzliche Sicherheitsmaßnahmen ergänzt werden, die eine Beschädigung von Komponenten der Magnetresonanzeinrichtung zuverlässig vermeiden können. Es reicht somit aus, wenn anhand der Prognosetemperatur ein Großteil der Fälle erkannt wird, in denen potentiell überhöhte Temperaturen auftreten können, wenn die geplante Sequenz durchgeführt wird. Hierdurch kann ein relativ einfaches Prognosemodell zur Ermittlung der Prognosetemperatur genutzt werden und es wird dennoch vermieden, dass geplante Messsequenzen unnötig stark modifiziert und/oder verzögert werden müssen, um eine Beschädigung von Komponenten in 100% der Fälle zu vermeiden. Hiermit ist es ausreichend, wenn beispielsweise 95% der Fälle erkannt werden, in denen bei Durchführung der geplanten Messsequenz überhöhte Temperaturen auftreten würden.

Der Energieeintrag der geplanten Messsequenz in die Magnetresonanzeinrichtung kann wenigstens 1,5-mal und/oder maximal 3-mal so groß sein wie die durch eine aktive und/oder passive Kühleinheit der Magnetresonanzeinrichtung während der Messsequenz abgeführte oder maximal abführbare Wärmeenergie. Anders ausgedrückt kann die geplante Messsequenz ausnutzen, dass aufgrund der thermischen Trägheit der Magnetresonanzeinrichtung beziehungsweise bestimmter Komponenten der Magnetresonanzeinrichtung kurzfristig höhere Energieeinträge erfolgen können, als sie durch die Kühleinheit abgeführt werden können. Es ist somit nicht notwendig, die Kühlung der Magnetresonanzeinrichtung beziehungsweise die Temperaturbeständigkeit der Komponenten der Magnetresonanzeinrichtung derart abzustimmen, dass ein dauerhafter Betrieb der Magnetresonanzeinrichtung mit Messsequenzen möglich ist, die sehr hohe Energiemengen in die Magnetresonanzeinrichtung eintragen. Solche Messsequenzen, beispielsweise eine Diffusionsbildgebung, werden im klinischen Alltag typischerweise eher selten und mit großem zeitlichen Abstand genutzt. Es kann somit ausreichend sein, die Magnetresonanzeinrichtung derart aufzubauen, dass beispielsweise nach einer bestimmten Zahl von Sequenzen mit relativ geringem Energieeintrag, beispielsweise Gradientenechos, eine einzelne Sequenz mit hohem Energieeintrag, beispielsweise eine Diffusionsbildgebung, durchgeführt werden kann. Beispielsweise kann es möglich sein, dass nur jede vierte Sequenz einen hohen Energieeintrag aufweist. Durch das erfindungsgemäße Verfahren kann hierbei bereits vor Beginn einer Messsequenz erkannt werden, ob diese konkrete Messsequenz beim momentanen Zustand der Magnetresonanzeinrichtung möglich ist oder ob sie verzögert werden sollte.

Neben dem erfindungsgemäßen Verfahren betrifft die Erfindung eine Magnetresonanzeinrichtung, die zur Durchführung des erfindungsgemäßen Verfahrens eingerichtet ist. Insbesondere kann die Magnetresonanzeinrichtung eine Steuereinrichtung aufweisen, die zur Steuerung von Gradientenspulen und/oder Hochfrequenzspulen der Magnetresonanzeinrichtung dient und diese Steuereinrichtung kann das erfindungsgemäße Verfahren implementieren. Die Steuereinrichtung kann insbesondere einen Speicher umfassen, der ein Programm speichert, das das erfindungsgemäße Verfahren implementiert und einen Prozessor, um die Verfahrensschritte auszuführen.

Daneben betrifft die Erfindung ein Computerprogramm, welches direkt in einen Speicher einer Steuereinrichtung ladbar ist, mit Programm-Mitteln, um die Schritte des erfindungsgemäßen Verfahrens durchzuführen, wenn das Programm in der Steuereinrichtung ausgeführt wird.

Zudem betrifft die Erfindung einen elektronisch lesbaren Datenträger mit darauf gespeicherten elektronisch lesbaren Steuerinformationen, welche zumindest ein erfindungsgemäßes Computerprogramm umfassen und derart ausgestaltet sind, dass sie bei Verwendung des Datenträgers in einer Steuereinrichtung das erfindungsgemäße Verfahren durchführen.

Weitere Vorteile und Einzelheiten der Erfindung ergeben sich aus den im Folgenden beschriebenen Ausführungsbeispielen sowie den zugehörigen Zeichnungen. Hierbei zeigen schematisch:
- Fig. 1: ein Ablaufdiagramm eines Ausführungsbeispiels eines erfindungsgemäßen Verfahrens,
- Fig. 2: ein Ausführungsbeispiel einer erfindungsgemäßen Magnetresonanzeinrichtung,
- Fig.3: die zur Durchführung eines Ausführungsbeispiels des erfindungsgemäßen Verfahrens genutzten Verarbeitungsmodule,
- Fig. 4: einen Ausschnitt eines Ablaufdiagramms eines weiteren Ausführungsbeispiels des erfindungsgemäßen Verfahrens, und
- Fig. 5: die im Rahmen eines Ausführungsbeispiels des erfindungsgemäßen Verfahrens genutzten Ein- und Ausgabedaten.

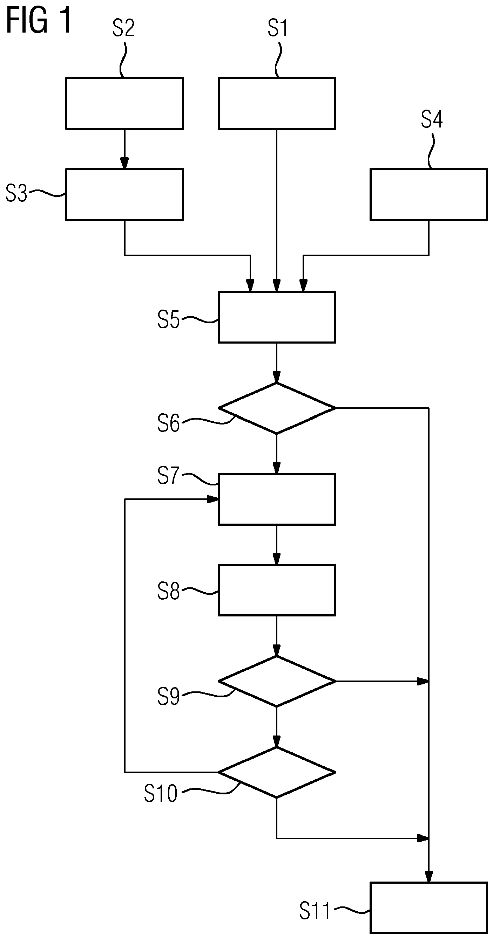

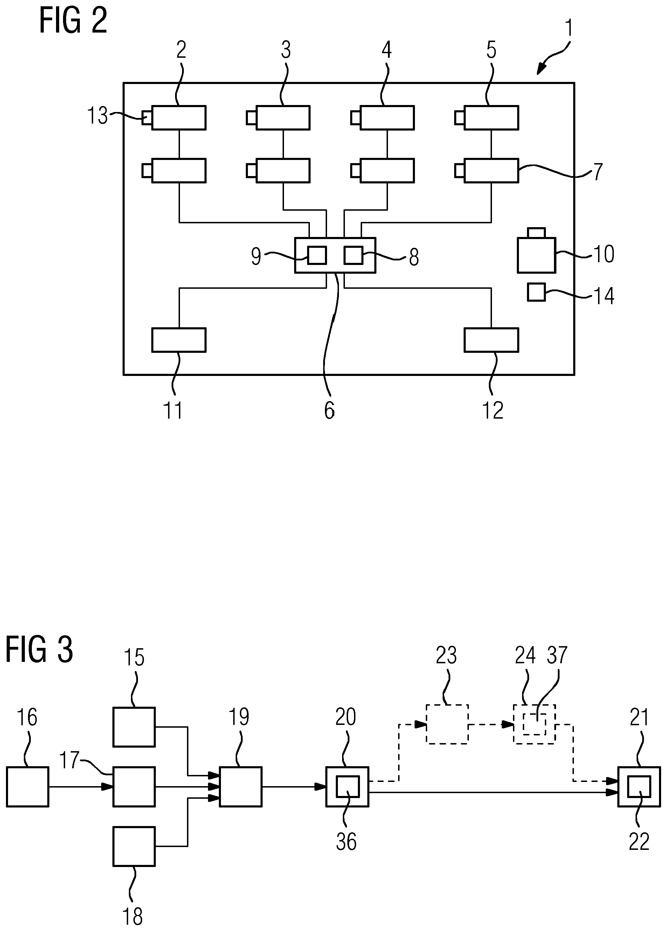

Fig. 1 zeigt ein Ablaufdiagramm zum Betrieb einer Magnetresonanzeinrichtung. Dieses Verfahren wird im Folgenden mit Bezug auf die in Fig. 2 schematisch dargestellte Magnetresonanzeinrichtung 1 erläutert. Hierbei zeigt Fig. 2 ausschließlich schematisch die für das erfindungsgemäße Verfahren relevanten Komponenten der Magnetresonanzeinrichtung 1, wobei die Anordnung der einzelnen Komponenten aus Übersichtlichkeitsgründen von der Anordnung in einer realen Magnetresonanzeinrichtung abweicht.

Die Magnetresonanzeinrichtung 1 weist unter anderem als Komponenten 2, 3, 4 drei Gradientenspulen auf, um ein Gradientenfeld in drei senkrecht aufeinander stehende Richtungen zu erzeugen. Hierbei werden typischerweise mehrere Gradientenspulen für jede der Raumrichtungen genutzt, wobei aus Übersichtlichkeitsgründen für jede Raumrichtung nur eine Gradientenspule dargestellt ist. Zudem umfasst die Magnetresonanzeinrichtung 1 als Komponente 5 wenigstens eine Hochfrequenzspule zur Einstrahlung von Hochfrequenzpulsen und zum Empfang von resultierenden Antwortsignalen. Die Gradientenspulen sowie die Hochfrequenzspule werden durch eine Steuereinrichtung 6 über eine jeweilige Ansteuerelektronik angesteuert, die schematisch als Komponente 7 dargestellt ist, die beispielsweise Vorverstärker, Filter und Ähnliches umfassen kann. Die Steuereinrichtung 6 kann beispielsweise dadurch implementiert werden, dass ein in einem Speicher 8 gespeichertes Programm durch einen Prozessor 9 ausgeführt wird, um die Gradientenspulen und die Hochfrequenzspule 5 über die entsprechende Ansteuerelektronik zur Durchführung der Messung zu steuern. Ein entsprechendes Programm kann auf einem nicht dargestellten Datenträger bereitgestellt werden.

Beim Betrieb generieren sowohl die Gradientenspulen und die Hochfrequenzspule als auch die Ansteuerelektronik und in einem geringeren Maße auch die Steuereinrichtung 6 Abwärme, die durch eine weitere Komponente 10 der Magnetresonanzeinrichtung 1 nämlich eine Kühleinheit, abgeführt werden muss, um eine Überhitzung der Komponenten 2 - 5, 7, 10 der Magnetresonanzeinrichtung zu vermeiden. Hierbei werden zumindest Teile der Komponenten 2 - 5, 7, 10 aktiv durch ein Kühlfluid gekühlt und zudem kann eine passive Kühlung zur Umgebung hin erfolgen.

Es ist bekannt, dass verschiedene Messsequenzen zu einem deutlich unterschiedlichen Energieeintrag in die Komponenten der Magnetresonanzeinrichtung 1 führen. Beispielsweise kann eine Diffusionsbildgebung einen um den Faktor 2 bis 4 höheren Energieeintrag bewirken als eine Gradientenechosequenz. Sollen verschiedene Messsequenzen durch die gleiche Magnetresonanzeinrichtung 1 ausführbar sein, wäre dies prinzipiell möglich, wenn die Kühleinheit ausreichend groß dimensioniert ist, um einen dauerhaften Betrieb der Magnetresonanzeinrichtung 1 mit jeder dieser Messsequenzen zu ermöglichen. Hierdurch würden jedoch relativ hohe Kosten entstehen, die typischerweise unnötig sind, da beispielsweise bei einer üblichen klinischen Nutzung einer Magnetresonanzeinrichtung Sequenzen mit einem hohen Energieeintrag nur relativ selten genutzt werden.

Es kann somit beispielsweise ausreichend sein, die Kühleinrichtung beziehungsweise die weiteren Komponenten 2 - 5, 7, 10 der Magnetresonanzeinrichtung 1 derart aufeinander abzustimmen, dass nur jede dritte, vierte oder fünfte genutzte Sequenz eine Sequenz mit hohem Energieeintrag sein darf. Da jedoch beim tatsächlichen Betrieb einer Magnetresonanzeinrichtung typischerweise unterschiedliche Umgebungsbedingungen, beispielsweise Umgebungstemperaturen, auftreten, zwischen den Sequenzen unterschiedliche Wartezeiten vorliegen, während denen die Magnetresonanzeinrichtung 1 nicht benutzt wird beziehungsweise ein Patient positioniert wird, unterschiedliche Komponententoleranzen für verschiedene Magnetresonanzeinrichtungen 1 auftreten und Ähnliches, ist es typischerweise nicht gewünscht, die Reihenfolge der nutzbaren Messsequenzen einzuschränken.

Um eine Beschädigung der Komponenten 2 - 5, 7, 10 der Magnetresonanzeinrichtung 1 beziehungsweise ein Abblasen von Kühlmittel zu vermeiden, wenn prinzipiell jede Messsequenz erlaubt wird, die Kühleinheit jedoch nicht ausreichend groß dimensioniert ist, um beispielsweise wiederholte Durchführungen von energienintensiven Messsequenzen zu erlauben, weist die Magnetresonanzeinrichtung 1 Temperatursensoren 13 an jenen Komponenten 2 - 5, 7, 10 auf, die für die Durchführbarkeit von Messsequenzen besonders relevant sind, nämlich an den Gradientenspulen, der Hochfrequenzspule, den Steuerelektroniken für die genannten Spulen und der Kühleinrichtung. Über aus Übersichtlichkeitsgründen nicht gezeigte Verbindungen werden die durch die Temperatursensoren 13 gemessenen aktuellen Temperaturen der Komponenten 2 - 5, 7, 10 an die Steuereinrichtung 6 bereitgestellt. Diese kann dazu eingerichtet sein, eine aktuell laufende Messsequenz abzubrechen, wenn eine Abbruchbedingung erfüllt ist, also beispielsweise wenn die Temperatur an einer der Komponenten 2 - 5, 7, 10 einen vorgegebenen Grenzwert überschreitet.

Ein derartiger Abbruch einer Messsequenz soll jedoch typischerweise vermieden werden, da er zu deutlichen Verzögerungen des Messbetriebs führt und somit einerseits den Patientenkomfort und andererseits den Durchsatz der Magnetresonanzeinrichtung 1 reduzieren kann. Daher implementiert die Steuereinrichtung 6 das in Fig. 1 als Ablaufdiagramm dargestellte Verfahren, das einen solchen Abbruch einer Messsequenz weitgehend verhindern kann. Hierbei wird ein allgemeines Modell für Magnetresonanzeinrichtungen genutzt, das anhand von Parametern der Magnetresonanzeinrichtung 1, der genutzten Messsequenz und von aktuellen Temperaturen, die über die Temperatursensoren 13 erfasst werden, Prognosetemperaturen für die Komponenten 2 - 5, 7, 10 der Magnetresonanzeinrichtung 1, also insbesondere für die Gradientenspulen, die Hochfrequenzspule, die Steuerelektroniken und die Kühleinheit, ermitteln kann.

Hierzu werden zunächst in Schritt S1 Parameter für die Magnetresonanzeinrichtung 1 vorgegeben. Beispielsweise können ein insbesondere temperatur- und/oder frequenzabhängiger Widerstand der Gradientenspulen und der Hochfrequenzspule und Regelparameter der Kühleinheit beziehungsweise der Mischbatterie 14 vorgegeben werden. Zudem können Wärmekapazitäten und/oder Wärme- und/oder Temperaturleitfähigkeiten der Gradientenspulen sowie der Hochfrequenzspule, Parameter der Steuerelektroniken und/oder Parameter, die einen Wärmetransport durch einen Kühlfluidfluss der Magnetresonanzeinrichtung 1 beschreiben, vorgegeben werden.

In Schritt S2 wird durch einen Benutzer, beispielsweise über eine Eingabeeinrichtung 11 der Magnetresonanzeinrichtung 1, eine Messsequenz ausgewählt, beziehungsweise Parameter einer Messsequenz vorgegeben. Je nachdem, ob beispielsweise ein Gradientenecho oder eine Diffusionsbildgebung gewählt werden ist mit einem deutlich unterschiedlichen Energieeintrag zu rechnen. Daher werden in Schritt S3 in Abhängigkeit der in Schritt S2 vorgegebenen Messsequenz beziehungsweise in Abhängigkeit von deren Parametern Sequenzparameter ausgewählt beziehungsweise ermittelt, die einen Energieeintrag in die Komponenten 2 - 5, 7, 10 der Magnetresonanzeinrichtung 1 beeinflussen. Dies kann beispielsweise ein Sequenztyp, eine Laufzeit der Sequenz, ein voraussichtlicher Leistungseintrag und/oder Energieeintrag in die Komponenten zur Erzeugung von Gradientenfeldern, also die Gradientenspulen und die zugehörige Steuerelektronik und/oder zur Erzeugung von Hochfrequenzpulsen, also die Hochfrequenzspule und die zugehörige Steuerelektronik sein. Ergänzend oder alternativ können ein Frequenzgehalt und/oder maximale und/oder mittlere Feldstärken des geplanten zeitlichen Verlaufs der Gradientenfelder und/oder Hochfrequenzfelder berücksichtigt werden. Insbesondere eine schnelle Modulation der Gradientenfelder kann den Energieeintrag in die Gradientenspulen und die Steuerelektronik deutlich erhöhen.

In Schritt S4 werden über die Temperatursensoren 13 die aktuellen Temperaturen der verschiedenen Komponenten 2 - 5, 7, 10 der Magnetresonanzeinrichtung 1 erfasst und in Schritt S5 werden die in Schritt Sl, S3 und S4 ermittelten Parameter genutzt, um Prognosetemperaturen für die einzelnen Komponenten 2 - 5, 7, 10 zu ermitteln. Das zur Ermittlung der Prognosetemperaturen genutzte Modell kann beispielsweise durch statistische Auswertung der Temperaturverläufe während Messungen mit Magnetresonanzeinrichtungen 1, durch ein Verfahren des Maschinenlernens oder ausgehend von Modellannahmen über die Magnetresonanzeinrichtung 1 bestimmt werden.

Im einfachsten Fall kann hierbei davon ausgegangen werden, dass die Temperatur der Komponenten 2 - 5, 7, 10 im Rahmen der geplanten Messsequenz kontinuierlich ansteigt und es kann nur ein jeweiliger Temperaturwert für die einzelnen Komponenten 2 - 5, 7, 10 zum Zeitpunkt des Abschlusses der Messsequenz ermittelt werden. Besonders bevorzugt wird jedoch anhand der Messsequenz selbst bestimmt, zu welchem Zeitpunkt die höchste Temperatur für die jeweilige Komponente 2 - 5, 7, 10 zu erwarten ist oder es werden Temperaturen für mehrere Zeitpunkte während der Messsequenz ermittelt, um möglichst robust eine maximale während der Messsequenz auftretende Temperatur für die einzelnen Komponenten 2 - 5, 7, 10 voraussagen zu können.

In Schritt S6 wird in Abhängigkeit der Prognosetemperaturen für die einzelnen Komponenten 2 - 5, 7, 10 ermittelt, ob eine Ausführbedingung erfüllt ist, bei deren Erfüllung die Messsequenz voraussichtlich problemlos ohne eine Überheizung von Komponenten 2 -5, 7, 10 durchgeführt werden kann. Beispielsweise können die Prognosetemperaturen der jeweiligen Komponenten 2 - 5, 7, 10 mit Grenzwerten für die Temperaturen der jeweiligen Komponenten 2 - 5, 7, 10 verglichen werden und nur wenn keiner der Grenzwerte überschritten wird, kann die Sequenz ausgeführt werden.

Ist die Ausführbedingung erfüllt, so werden in Schritt S7 die Komponenten 2 - 5, 7, 10 der Magnetresonanzeinrichtung 1 angesteuert, um die Messsequenz durchzuführen. Hierbei wird wiederholt in Schritt S8 über die jeweiligen Temperatursensoren 13 die Temperatur der Komponenten 2 - 5, 7, 10 erfasst und in Schritt S9 überprüft, ob die Messsequenz aufgrund einer Temperaturüberhöhung abgebrochen werden muss. Hierdurch ist es nicht erforderlich, dass die Erfüllung der Ausführbedingung in Schritt S6 mit hundertprozentiger Sicherheit garantiert, dass keine Übertemperaturen auftreten. Es ist ausreichend, wenn ein Großteil jener Fälle erkannt wird, bei denen Übertemperaturen auftreten können. In den verbleibenden Fällen kann durch Prüfung der Abbruchbedingungen in Schritt S9 dennoch eine Beschädigung der Komponenten 2 - 5, 7, 10 vermieden werden.

In Schritt S10 wird überprüft, ob die Messsequenz bereits abgeschlossen ist. Ist dies nicht der Fall, so wird das Verfahren ab Schritt S7 wiederholt. Anderenfalls wird die Messsequenz in Schritt S11 beendet. Hierbei können entsprechende Informationen beziehungsweise Messergebnisse an der Ausgabeeinrichtung 12 der Magnetresonanzeinrichtung 1 ausgegeben werden.

Wird in Schritt S6 ermittelt, dass die Ausführbedingung nicht erfüllt ist, beispielsweise weil wenigstens eine der Prognosetemperaturen einen zugeordneten Grenzwert überschreitet, wird in dem gezeigten Ausführungsbeispiel unmittelbar zu Schritt S11 verzweigt, also das Verfahren beendet, ohne dass die Messsequenz ausgeführt wird. Hierbei kann ein entsprechender Hinweis an einen Benutzer ausgegeben werden. Dieser kann den Benutzer beispielsweise anweisen, zunächst eine Kühlphase abzuwarten oder vorschlagen, eine andere Sequenz zu nutzen. Wie später noch erläutert werden wird, wäre es alternativ auch möglich, die geplante Messsequenz automatisiert zu modifizieren und/oder zu verzögern, um das Auftreten von Übertemperaturen zu vermeiden.

Fig. 3 zeigt eine beispielhafte Architektur, mit der das zu Fig. 1 erläuterte Verfahren umgesetzt werden kann. Hierbei können die im Folgenden erläuterten Module beispielsweise als Software implementiert sein, die in den Speicher 8 der Steuereinrichtung 9 geladen wird und durch den Prozessor 9 ausgeführt wird. Alternativ können auch Teile oder alle der Module durch dedizierte Hardware, beispielsweise einen ASIC oder einen FPGA, implementiert werden.

Das Parametermodul 15 stellt die zu Schritt S1 diskutierten Parameter der Magnetresonanzeinrichtung 1 bereit. Durch das Vorgabemodul 16 werden die Benutzereingaben in Schritt S2 erfasst und das Sequenzparameterermittlungsmodul 17 wählt beziehungsweise ermittelt die zur Temperaturprognose genutzten Sequenzparameter. Das Temperaturerfassungsmodul 18 erfasst über die Temperatursensoren 13 die aktuellen Temperaturen der Komponenten. Das zu Schritt S5 erläuterte Modell wird durch ein Prognosetemperaturermittlungsmodul 19 implementiert und die resultierenden Prognosetemperaturen werden, wie zu Schritt S6 erläutert, durch das Prüfmodul 20 verarbeitet, das die Prüfung der Ausführungsbedingung 36 implementiert. Die zu Schritt S7 bis S10 erläuterte Sequenzsteuerung erfolgt durch das Sequenzsteuermodul 21, das auch ein Prüfmodul implementiert, das die mit Bezug zu Schritt S8 und S9 erläuterte Prüfung der Abbruchbedingung 22 durchführt.

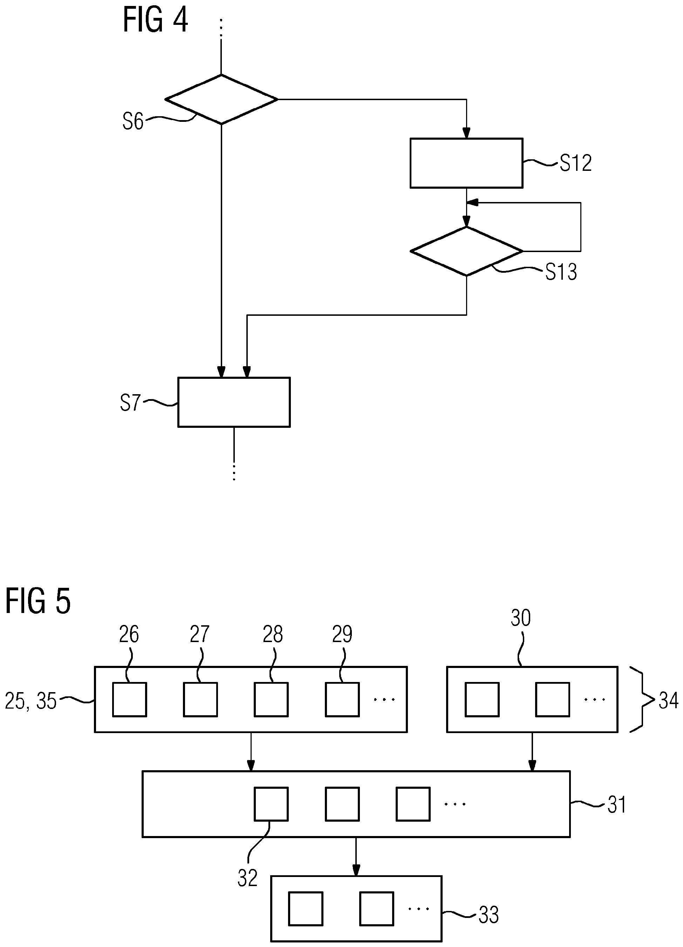

Das vorangehend erläuterte Vorgehen, bei dem die Ausführung der Messsequenz vollständig verhindert wird, wenn die Ausführbedingung nicht erfüllt wird, kann von Benutzern unter Umständen als unkomfortabel empfunden werden und erreicht nicht notwendigerweise die optimale Ausnutzung der Magnetresonanzeinrichtung 1. Daher kann es vorteilhaft sein, bei Nichterfüllung der Ausführbedingung 36 in Schritt S6 statt der in Fig. 1 gezeigten Verzweigung zu Schritt S11 und somit einer Beendigung des Verfahrens die Messsequenz automatisiert zu modifizieren und/oder zu verzögern. Ein beispielhaftes Vorgehen, bei dem beide Ansätze genutzt werden, wird im Folgenden mit Bezug auf Fig. 3 und Fig. 4 erläutert. Hierbei wird zunächst in Schritt S12 durch das Modifikationsmodul 23 die Messsequenz modifiziert, so dass statt der geplanten Messsequenz eine modifizierte Messsequenz ausgeführt wird. Beispielsweise kann die Anzahl der aufgenommenen Schichten, die Schnelligkeit einer Gradientenänderung, der Abstand zwischen der Erfassung von Schichten oder Ähnliches modifiziert werden, um zu erreichen, dass der Energieeintrag in die Komponenten 2 - 5, 7, 10 der Magnetresonanzeinrichtung 1 reduziert beziehungsweise zwischen den Energieeinträgen liegende Kühlzeiten verlängert werden.

Anschließend wird die Ausführung der modifizierten Messsequenz zusätzlich durch ein Verzögerungsmodul 24 verzögert. Um dies zu erreichen wird in Schritt S13 wiederholt, insbesondere periodisch, geprüft, ob eine Auslösebedingung 37 erfüllt ist. Die Auslösebedingung 37 kann im einfachsten Fall von der Zeit abhängen, die seit Nichterfüllung der Ausführbedingung 36 in Schritt S6 verstrichen ist. Beispielsweise kann kontinuierlich ein Zähler erhöht werden und bei Erreichen eines Grenzwertes kann mit der Ausführung der modifizierten Messsequenz begonnen werden, was, wie vorangehend zu Schritt S7 erläutert, erfolgen kann. Besonders bevorzugt prüft die Auslösebedingung jedoch über die Temperatursensoren 13 erfasste Temperaturen oder aus diesen, wie vorangehend erläutert, ermittelte Prognosetemperaturen, die voraussichtlich während der Durchführung der modifizierten Messsequenz auftreten werden. Hierdurch kann eine optimale Verzögerungszeit erreicht werden.

In den bisherigen Ausführungsbeispielen wurden jeweils nur zwei mögliche Ergebnisse der Prüfung der Ausführbedingung 36 erläutert. Entweder die geplante Messsequenz wird unmittelbar ausgeführt oder die geplante Messsequenz wird nicht beziehungsweise in modifizierter Form und verzögert ausgeführt. Ergänzend sind auch andere Varianten möglich, bei denen beispielsweise ausschließlich eine Modifikation der Messsequenz oder ausschließlich eine Verzögerung erfolgt oder bei denen eine Ausführung der geplanten oder der modifizierten Messsequenz erst nach einer Benutzereingabe zur Bestätigung erfolgt. Hierbei können auch verschiede Möglichkeiten parallel genutzt werden. Beispielsweise können für wenigstens eine der Komponenten 2 - 5, 7, 10 mehrere Grenzwerte für die Prognosetemperatur vorgesehen sein. Wird keiner dieser Grenzwerte überstiegen, kann die geplante Messsequenz unmodifiziert durchgeführt werden. Bei einer geringfügigen Überschreitung des niedrigsten Grenzwertes kann es beispielsweise ausreichend sein, einen Benutzer hierauf hinzuweisen beziehungsweise eine Bestätigung des Benutzers abzuwarten, dass die geplante Messsequenz tatsächlich durchgeführt werden soll oder ihm mehrere Wahlmöglichkeiten zu geben, ob er die Messsequenz durchführen möchte oder eine Modifikation wünscht. Bei einer Überschreitung eines weiteren Grenzwertes kann die Durchführung der Messsequenz nur nach einer Modifikation oder Verzögerung zugelassen werden und ein dritter Grenzwert kann genutzt werden, um die Ausführung der Messsequenz vollständig zu verhindern. Das erläuterte Verfahren kann auf vielfältige Weise variiert werden, um in einem gegebenen Anwendungsszenario zu einem optimalen Benutzerkomfort und/oder einem optimalen Durchsatz für die Magnetresonanzeinrichtung zu führen.

Wie bereits erläutert werden die Prognosetemperaturen durch ein entsprechendes Modell ermittelt. Dies ist schematisch in Fig. 5 dargestellt. Hierbei ist das Modell 31 durch eine Vielzahl von Einrichtungsparametern 32 der Magnetresonanzeinrichtung 1 parametrisiert. Ein derart parametrisiertes Modell 31 kann beispielsweise durch jeweilige Funktionen für die einzelnen Prognosetemperaturen 33 ausgedrückt werden, die jeweils zumindest von Teilen der Eingangsparameter 34 des Modells 31 abhängen. Die Eingangsparameter 34 sind, wie vorangehend erläutert, Sequenzparameter 25 der Messsequenz 35 und die über die Temperatursensoren 13 ermittelten aktuellen Temperaturen 30. Als Sequenzparameter 25 sind beispielhaft ein Sequenztyp 26, eine Laufzeit 27 der geplanten Messsequenz 35, Feldstärken 28 für die Gradientenfelder beziehungsweise Hochfrequenzpulse und der Frequenzgehalt 29 des geplanten zeitlichen Verlaufs der Gradientenfelder beziehungsweise Hochfrequenzpulse dargestellt.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Betrieb einer Magnetresonanzeinrichtung (1), umfassend die Schritte:
- Vorgeben einer geplanten Messsequenz (35),
- Erfassen einer aktuellen Temperatur (30) wenigstens einer Komponente (2 - 5, 7, 10) der Magnetresonanzeinrichtung (1) durch einen jeweiligen Temperatursensor (13) der Magnetresonanzeinrichtung (1), und
- Ermitteln einer jeweiligen Prognosetemperatur (33) für die Komponente (2 - 5, 7, 10) oder wenigstens eine der Komponenten (2 - 5, 7, 10) für wenigstens einen Zeitpunkt während der Ausführung und/oder nach Abschluss der geplanten Messsequenz (35) in Abhängigkeit der aktuellen Temperatur (30) und der geplanten Messsequenz (35).

2. Verfahren nach Anspruch 1, **dadurch gekennzeichnet, dass** die Ausführung der geplanten Messsequenz (35) von der Erfüllung einer von der Prognosetemperatur (33) abhängigen Ausführbedingung (36) abhängt.

3. Verfahren nach Ansprüche 2, **dadurch gekennzeichnet, dass** bei Nichterfüllung der Ausführbedingung (36) wenigstens ein Sequenzparameter (25) der geplanten Messsequenz (35) modifiziert wird und statt der geplanten Messsequenz (35) die derart modifizierte Messsequenz ausgeführt wird.

4. Verfahren nach Anspruch 2 oder 3, **dadurch gekennzeichnet, dass** bei Nichterfüllung der Ausführbedingung (36) die geplante Messsequenz (35) nicht oder die geplante oder modifizierte Messsequenz erst bei Erfüllung einer Auslösebedingung (37) ausgeführt wird.

5. Verfahren nach Anspruch 4, **dadurch gekennzeichnet, dass** die Erfüllung der Auslösebedingung (37) von einem seit der Prüfung der Erfüllung der Ausführbedingung (36) verstrichenen Zeitintervall oder von dem Erfassen einer Bestätigungseingabe eines Benutzers abhängt oder dass nach Nichterfüllung der Ausführbedingung (36) zu wenigstens einem Prüfzeitpunkt für wenigstens eine Komponente (2 - 5, 7, 10) eine weitere Temperatur erfasst wird, wobei die Erfüllung Auslösebedingung (37) von der weiteren Temperatur oder einer in Abhängigkeit der weiteren Temperatur prognostizierten weiteren Prognosetemperatur abhängt.

6. Verfahren nach einem der vorangehenden Ansprüche, **dadurch gekennzeichnet, dass** die geplante Messsequenz (35) wenigstens einen Sequenzparameter (25) aufweist, der die Ansteuerung wenigstens einer Komponente (2 - 5, 7, 10) der Magnetresonanzeinrichtung im Rahmen der Messsequenz betrifft, wobei die Prognosetemperatur (33) in Abhängigkeit des Sequenzparameters (25) ermittelt wird.

7. Verfahren nach Anspruch 6, **dadurch gekennzeichnet, dass** als Sequenzparameter (25) ein Sequenztyp (26) und/oder eine Laufzeit (27) und/oder ein voraussichtlicher Leistungseintrag und/oder Energieeintrag in Komponenten (2 -5, 7, 10) zur Erzeugung von Gradientenfeldern und/oder von Hochfrequenzpulsen und/oder ein Frequenzgehalt (29) und/oder maximale und/oder mittlere Feldstärken (28) des geplanten zeitlichen Verlaufs der Gradientenfelder und/oder der Hochfrequenzpulse der geplanten Messsequenz (35) bei der Ermittlung der Prognosetemperatur (33) berücksichtigt werden.

8. Verfahren nach einem der vorangehenden Ansprüche, **dadurch gekennzeichnet, dass** die Prognosetemperatur (33) anhand eines Modells (31) der Magnetresonanzeinrichtung (1) ermittelt wird, das in Abhängigkeit wenigstens eines eine Eigenschaft der Magnetresonanzeinrichtung (1) beschreibenden Einrichtungsparameters (32) parametrisiert ist oder wird.

9. Verfahren nach Anspruch 8, **dadurch gekennzeichnet, dass** als Einrichtungsparameter (32) ein Widerstand wenigstens einer Gradientenspule und/oder wenigstens einer Hochfrequenzspule, insbesondere ein temperaturabhängiger und/oder frequenzabhängiger Widerstand der Gradientenspule und/oder Hochfrequenzspule, und/oder wenigstens eine die Speicherung und/oder den Transport von Wärmeenergie in der Magnetresonanzeinrichtung (1) betreffende Einrichtungskonstante und/oder wenigstens ein Regelparameter, der ein Regelverhalten einer Kühleinheit und/oder einer Mischerbatterie (14) betrifft, verwendet werden.

10. Verfahren nach Anspruch 9, **dadurch gekennzeichnet, dass** die Einrichtungskonstante oder wenigstens eine der Einrichtungskonstanten eine Wärmekapazität und/oder eine Wärmeleitfähigkeit und/oder eine Temperaturleitfähigkeit der Gradientenspule und/oder der Hochfrequenzspule und/oder einen Wärmetransport durch einen Kühlfluidfluss in der Magnetresonanzeinrichtung (1) beschreibt.

11. Verfahren nach einem der vorangehenden Ansprüche, **dadurch gekennzeichnet, dass** während der Ausführung der geplanten oder der modifizierten Messsequenz (35) wiederholt die momentane Temperatur der Komponente (2 - 5, 7, 10) oder wenigstens einer der Komponenten (2 - 5, 7, 10) erfasst wird, wonach bei Erfüllung einer Abbruchbedingung (22), deren Erfüllung von der momentanen Temperatur abhängt, die Messsequenz (35) abgebrochen wird.

12. Verfahren nach einem der vorangehenden Ansprüche, **dadurch gekennzeichnet, dass** der Energieeintrag der geplanten Messsequenz (35) in die Magnetresonanzeinrichtung (1) wenigsten 1,5-mal und/oder maximal 3-mal so groß ist wie die durch eine aktive und/oder passive Kühleinheit der Magnetresonanzeinrichtung (1) während der Messsequenz (35) abgeführte oder maximal abführbare Wärmeenergie.

13. Magnetresonanzeinrichtung, **dadurch gekennzeichnet, dass** sie zur Durchführung des Verfahrens nach einem der vorangehenden Ansprüche eingerichtet ist.

14. Computerprogramm, welches direkt in einen Speicher (8) einer Steuereinrichtung (6), insbesondere eine Steuereinrichtung (6) einer Magnetresonanzeinrichtung (1), ladbar ist, mit Programm-Mitteln, um die Schritte des Verfahrens nach einem der Ansprüche 1 bis 12 durchzuführen, wenn das Programm in der Steuereinrichtung (6) ausgeführt wird.

15. Elektronisch lesbarer Datenträger mit darauf gespeicherten elektronisch lesbaren Steuerinformationen, welche zumindest ein Computerprogramm nach Anspruch 14 umfassen und derart ausgestaltet sind, dass sie bei Verwendung des Datenträgers in einer Steuereinrichtung (6), insbesondere einer Steuereinrichtung (6) einer Magnetresonanzeinrichtung, das Verfahren nach einem der Ansprüche 1 bis 12 durchführen.
